(19) Europäisches Patentamt / European Patent Office / Office européen des brevets

(11) **EP 3 764 136 B1**

(12) **FASCICULE DE BREVET EUROPEEN**

(45) Date de publication et mention
de la délivrance du brevet:
**22.02.2023 Bulletin 2023/08**

(21) Numéro de dépôt: **20184814.0**

(22) Date de dépôt: **08.07.2020**

(51) Classification Internationale des Brevets (IPC):
*G02B 6/14* *(2006.01)*     *G02B 6/12* *(2006.01)*
*G02B 6/122* *(2006.01)*     *H01S 5/10* *(2006.01)*
*H01S 5/14* *(2006.01)*

(52) Classification Coopérative des Brevets (CPC):
G02B 6/14; **G02B 6/12002; G02B 6/1228;**
**H01S 5/1032; H01S 5/141;** G02B 6/12004;
G02B 2006/12152; H01S 5/021; H01S 5/1014;
H01S 5/1035

(54) **PROCEDE DE FABRICATION D'UN TRANSFORMATEUR DE MODE ADIABATIQUE ENTRE DEUX GUIDES D'ONDE**

VERFAHREN ZUR HERSTELLUNG EINES ADIABATISCHEN MODENTRANSFORMATORS ZWISCHEN ZWEI WELLENLEITERN

METHOD FOR MANUFACTURING AN ADIABATIC MODE TRANSFORMER BETWEEN TWO WAVEGUIDES

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **11.07.2019 FR 1907814**

(43) Date de publication de la demande:
**13.01.2021 Bulletin 2021/02**

(73) Titulaire: **Commissariat à l'Energie Atomique et
aux Energies
Alternatives
75015 Paris (FR)**

(72) Inventeurs:
• **WILMART, Quentin**
 **38054 Grenoble Cedex 9 (FR)**
• **HASSAN, Karim**
 **38054 Grenoble Cedex 9 (FR)**

(74) Mandataire: **INNOV-GROUP
310, avenue Berthelot
69372 Lyon Cedex 08 (FR)**

(56) Documents cités:
US-A1- 2015 380 905     US-A1- 2016 266 321

• HELENE DUPREZ ET AL: "1310 nm hybrid InP/InGaAsP on silicon distributed feedback laser with high side-mode suppression ratio", OPTICS EXPRESS, vol. 23, no. 7, 25 mars 2015 (2015-03-25), page 8489, XP055197550, DOI: 10.1364/OE.23.008489
• XIANKAI SUN ET AL: "Adiabaticity riterion and the shortest adiabatic mode transformer in a coupled-waveguide system", OPTICS LETTERS, OPTICAL SOCIETY OF AMERICA, US, vol. 34, no. 3, 1 février 2009 (2009-02-01), pages 280-282, XP001521869, ISSN: 0146-9592, DOI: 10.1364/OL.34.000280
• MU JINFENG ET AL: "Design and length optimization of an adiabatic coupler for on-chip vertical integration of rare-earth-doped double tungstate waveguide amplifiers", 2014 16TH INTERNATIONAL CONFERENCE ON TRANSPARENT OPTICAL NETWORKS (ICTON), IEEE, 6 juillet 2014 (2014-07-06), pages 1-4, XP032627381, DOI: 10.1109/ICTON.2014.6876570
• POULOPOULOS G ET AL: "Angled 3D Glass-to-Silicon Photonics Coupling Interface", IEEE PHOTONICS TECHNOLOGY LETTERS, IEEE SERVICE CENTER, PISCATAWAY, NJ, US, vol. 29, no. 9, 1 mai 2017 (2017-05-01), pages 763-766, XP011646088, ISSN: 1041-1135, DOI: 10.1109/LPT.2017.2684222 [extrait le 2017-04-14]

**Description**

**DOMAINE TECHNIQUE**

Le domaine de l'invention est celui du couplage adiabatique entre des guides d'onde superposés l'un à l'autre d'un transformateur de mode. Les guides d'onde peuvent notamment être un premier guide d'onde contenant un matériau à gain d'une source laser, couplé à un deuxième guide d'onde d'un circuit photonique intégré.

**ÉTAT DE LA TECHNIQUE ANTÉRIEURE**

D'une manière générale, une puce photonique comporte au moins un composant optoélectronique, par exemple une source laser, qui repose sur un substrat support contenant un circuit photonique intégré. Un tel circuit photonique intégré comporte un guide d'onde, couplé à la source laser, ainsi que des composants optiques actifs (modulateurs...) et/ou passifs (multiplexeurs...). Dans le cas des technologies de la photonique sur silicium, la source laser est réalisée à base d'un composé semiconducteur, par exemple un composé III-V tel que de l'InP, et le substrat support peut être de type SOI (*Silicon On Insulator,* en anglais) intégrant des guides d'onde en silicium.

La source laser est dite hybride lorsque la cavité optique de la source laser est définie par des réflecteurs situés dans le substrat support. Plus précisément, la source laser est formée d'un plot semiconducteur en un composé III-V qui comporte le matériau à gain. Le matériau à gain est situé dans un guide d'onde dit actif. Dans le cas d'un laser DBR (*Distributed Bragg Reflector,* en anglais), la cavité optique est délimitée par deux réseaux de Bragg situés dans le guide d'onde intégré, qui forment des miroirs sélectifs en longueur d'onde. Dans le cas d'un laser DFB (*Distributed FeedBack,* en anglais), un même réseau de Bragg s'étend dans le guide d'onde intégré sur toute la longueur de la cavité optique.

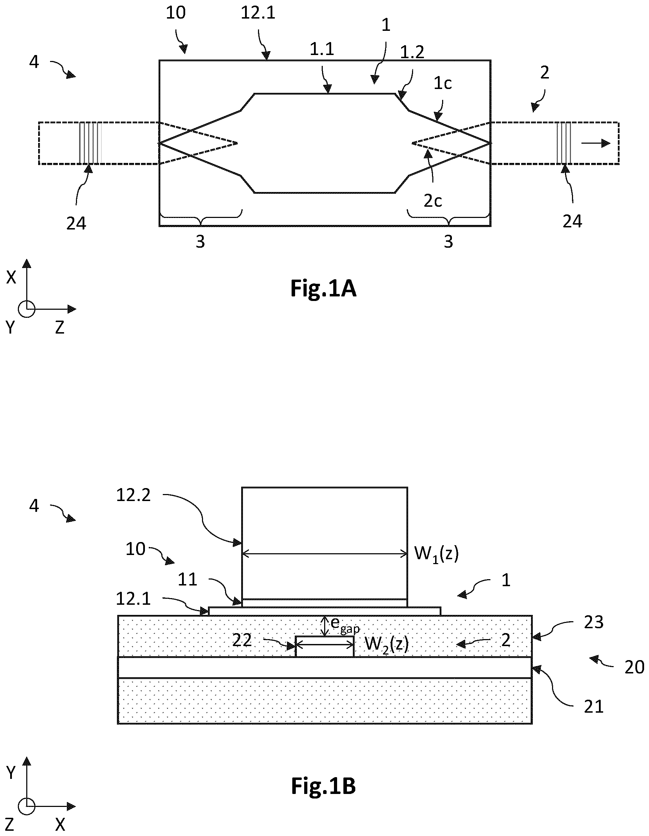

Les figures 1A et 1B sont des vues en coupe d'un exemple de source laser hybride 4 décrit notamment dans l'article de Duan et al. intitulé Hybrid III-V on Silicon Lasers for Photonic Integrated Circuits on Silicon, IEEE J. Sel. Topics Quantum Electron., Vol.20, No.4, 2014. La source laser 4 comporte des transformateurs de mode 3, situés aux extrémités longitudinales du guide d'onde actif 1, qui assurent un couplage adiabatique entre le guide d'onde actif 1 et le guide d'onde intégré 2 superposés l'un à l'autre. La source laser 4 est formée d'un plot semiconducteur 10 contenant des puits quantiques 11 disposés dans le guide d'onde actif 1. Le substrat support 20 comporte le guide d'onde intégré 2, ici un guide en arête formé d'une base 21 (*slab,* en anglais) sur laquelle repose une arête 22 (*rib,* en anglais). Chaque transformateur de mode 3 est formé d'un coupleur 1c du guide d'onde actif 1 et d'un coupleur 2c du guide d'onde intégré 2, les coupleurs 1c, 2c présentant une variation monotone, ici linéaire, de leurs largeurs $W_1$ et $W_2$ sur une longueur L suivant l'axe longitudinal Z. Les coupleurs 1c, 2c sont ici des pointes inversées (*inversed tapers,* en anglais).

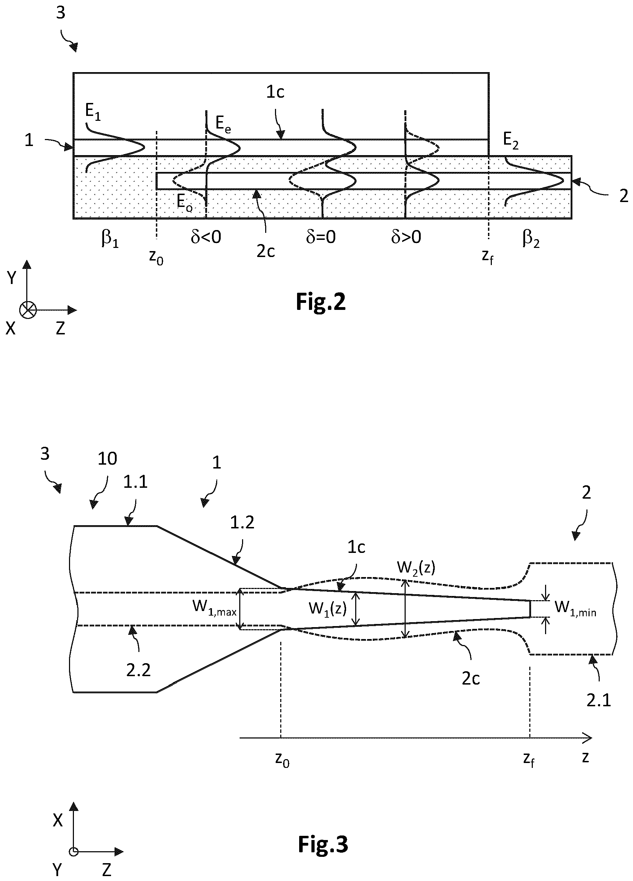

La figure 2 est une vue schématique, en coupe longitudinale, d'un transformateur de mode adiabatique 3 de la source laser 4 illustrée sur les fig.1A et 1B. Pour un guide d'onde isolé noté i, c'est-à-dire pour un guide d'onde non couplé à un autre guide d'onde, on définit une constante de propagation $\beta_{i=1,2}$ telle que $\beta_i = 2\pi n_{eff,i}/\lambda$, associée au mode fondamental de longueur d'onde A et d'indice effectif $n_{eff,i}$ se propageant suivant l'axe longitudinal Z. Ainsi, le mode fondamental se propageant dans le guide d'onde actif 1 isolé, i.e. non couplé au guide d'onde intégré 2, présente une constante de propagation $\beta_1$, et le mode fondamental se propageant dans le guide d'onde intégré 2 isolé (non couplé au guide d'onde actif 1) présente une constante de propagation $\beta_2$. On peut définir un paramètre $\delta$ représentatif de l'écart entre les deux constantes de propagation, tel que $\delta = (\beta_2 - \beta_1)/2$. Notons que le paramètre $\delta$, dans le cas du transformateur de mode illustré sur les fig.1A et 1B, varie suivant l'axe longitudinal Z : $\delta(z) = (\beta_2[W_2[z]] - \beta_1[W_1(z)])/2$, dans la mesure où la variation longitudinale des largeurs $W_1$, $W_2$ induisent une variation longitudinale des indices effectifs $n_{eff,1}$, $n_{eff,2}$, et donc des constantes de propagation $\beta_1$, $\beta_2$.

Dans le transformateur de mode 3, les deux coupleurs 1c, 2c sont suffisamment proches l'un de l'autre pour être couplés optiquement. Ils forment ainsi un système couplé dans lequel l'amplitude du champ électrique $E_1$, $E_2$ de chaque mode fondamental isolé présente une distribution spatiale qui s'étend sur chacun des deux coupleurs 1c, 2c. Autrement dit, le système couplé supporte des supermodes, pair $E_e$ (*even,* en anglais) ou impair $E_o$ (*odd,* en anglais), lesquels sont définis comme étant des combinaisons linéaires des modes fondamentaux $E_1$, $E_2$ du guide d'onde actif 1 isolé et du guide d'onde intégré 2 isolé. Comme pour les modes fondamentaux $E_1$, $E_2$, on définit des constantes de propagation $\beta_e$, $\beta_o$ pour les supermodes pair $E_e$ et impair $E_o$ en fonction des indices effectifs $n_{eff,e}$, $n_{eff,o}$. Le système couplé est alors défini par les constantes de propagation $\beta_1$, $\beta_2$ des modes fondamentaux isolés, par les constantes de propagation $\beta_e$, $\beta_o$ des supermodes pair et impair, et par un paramètre de couplage $\kappa$ qui représente la force de couplage entre les deux coupleurs 1c, 2c. Comme le décrit Duan et al 2014 et comme l'illustre schématiquement la fig.1C, la variation longitudinale des largeurs $W_1$, $W_2$ permet de modifier l'indice effectif $n_{eff,1}$, $n_{eff,2}$ des modes fondamentaux $E_1$, $E_2$ des guides d'onde isolés, et donc les indices effectifs $n_{eff,e}$, $n_{eff,o}$ des supermodes $E_e$, $E_o$, de manière à assurer le transfert dit adiabatique du mode optique d'un guide d'onde à l'autre. L'efficacité de couplage, c'est-à-dire le rapport entre la puissance optique $P_{out}$ dans le guide d'onde de sortie sur la puissance optique $P_{in}$ dans le guide d'onde d'entrée, dépend de la longueur L du transformateur de mode. Notons que le couplage n'est pas adiabatique lorsque l'efficacité de couplage montre de fortes oscillations (battements) en fonction de la longueur L du transformateur de mode 3, ces oscillations correspondant à des interférences constructives et destructives entre les supermodes pair et impair (les deux étant excités).

Cependant, il existe un besoin de disposer d'un procédé de fabrication d'un transformateur de mode qui présente des performances améliorées.

Par ailleurs, notons que l'article de Duprez et al. intitulé 1310nm hybrid InP/InGaAsP on silicon distributed feedback laser with high side-mode suppression ratio, Optics Express, Vol.23, No.7, 2015, décrit la fabrication d'un transformateur de mode adiabatique où seul l'un des coupleurs est en pointe. Cependant, il ne décrit pas de procédé de fabrication d'un tel transformateur de mode dans le cas où les deux coupleurs présentent chacun une variation longitudinale de la largeur.

De plus, le document US2016/266321 décrit un transformateur de mode adiabatique comportant deux coupleurs en pointe inversés. La variation longitudinale de la largeur des coupleurs peut être linéaire ou non. Cependant, il ne décrit pas non plus un procédé de fabrication d'un tel transformateur de mode dont les performances seraient alors améliorées.

## EXPOSÉ DE L'INVENTION

L'invention a pour objectif de remédier au moins en partie aux inconvénients de l'art antérieur, et plus particulièrement de proposer un procédé de fabrication d'un transformateur de mode aux performances améliorées, que ce soit par exemple en termes d'efficacité de couplage ou de longueur du transformateur de mode.

Pour cela, un objet de l'invention est un procédé de fabrication d'un transformateur de mode assurant le couplage adiabatique entre un premier guide d'onde et un deuxième guide d'onde, le transformateur de mode étant formé d'un premier coupleur du premier guide d'onde et d'un deuxième coupleur du deuxième guide d'onde, les premier et deuxième coupleurs étant superposés l'un à l'autre et présentant une largeur variable, respectivement $W_1$ et $W_2$, sur une longueur L suivant un axe longitudinal, le procédé comportant les étapes suivantes :

- définition d'une part d'une variation longitudinale $W_1 = f_1(z)$ de la largeur $W_1$ du premier coupleur, entre des positions zo et $z_f$ suivant l'axe longitudinal telles que $z_f = z_0 + L$, allant d'une valeur maximale $W_{1,max}$ en zo à une valeur minimale $W_{1,min}$ en $z_f$, et d'autre part de valeurs dites provisoires minimale $W_{2,pmin}$ et maximale $W_{2,pmax}$ de la largeur $W_2$ du deuxième coupleur ;
- détermination de constantes de propagation $\beta_e$ et $\beta_o$ associées respectivement à des supermodes pair et impair supportés par les deux coupleurs, pour chaque position z entre $z_0$ et $z_f$, en fonction :

  ◦ de la valeur locale $W_1(z)$ en z de la largeur $W_1$ du premier coupleur, et
  ◦ d'une valeur locale $\hat{W}_2(z)$ en z de la largeur $W_2$ du deuxième coupleur, pour laquelle il y a égalité entre des constantes de propagation $\beta_1(W_1(z))$ et $\beta_2(\hat{W}_2(z))$ associés respectivement aux modes fondamentaux supportés par le premier coupleur de largeur locale $W_1(z)$ et par le deuxième coupleur de largeur locale $\hat{W}_2(z)$, les deux coupleurs étant alors isolés l'un de l'autre ;

- détermination d'une variation longitudinale $\kappa = h(z)$ entre zo et $z_f$ du paramètre de couplage $\kappa$ entre les deux coupleurs, à partir d'une différence entre les constantes de propagation $\beta_e$ et $\beta_o$ déterminées ;
- détermination d'une variation longitudinale $W_2 = f_2(z)$ entre zo et $z_f$ de la largeur $W_2$ du deuxième coupleur de telle sorte que le critère d'adiabaticité est vérifié à chaque position z, ce critère d'adiabaticité reliant la position z considérée, la longueur L prédéfinie, le paramètre de couplage $\kappa(z)$ prédéterminé, ladite constante de propagation $\beta_1(W_1(z))$, et une constante de propagation $W_2 = f_2(z)$ associée à une valeur locale $W_2(z)$ à déterminer ;
- fabrication du transformateur de mode, dans lequel le premier coupleur présente la variation longitudinale $W_1 = f_1(z)$ définie, et le deuxième coupleur présente la variation longitudinale $W_2 = f_2(z)$ déterminée.

Certains aspects préférés mais non limitatifs de ce procédé de fabrication sont les suivants.

Le procédé de fabrication peut comporter :

- à la suite de l'étape de détermination de la variation longitudinale $W_2 = f_2(z)$, une étape de détermination d'une efficacité de couplage définie comme le rapport $P_{out}/P_{in}$ entre un paramètre représentatif d'une puissance optique $P_{out}$ d'un mode fondamental en sortie du transformateur de mode et un paramètre représentatif d'une puissance optique $P_{in}$ d'un mode fondamental en entrée du transformateur de mode,
- réitération des étapes allant de l'étape de définition à l'étape de détermination de l'efficacité de couplage, pour différentes valeurs de la longueur L ;
- détermination d'une valeur minimale de la longueur L pour laquelle la variation de l'efficacité de couplage en fonction de la longueur L est inférieure ou égale à un seuil prédéfini.

Le procédé de fabrication peut comporter les étapes suivantes :

- détermination de la constante de propagation $\beta_1(W_1)$ associée au mode fondamental supporté par le premier coupleur isolé du deuxième coupleur, en fonction de la largeur $W_1$ allant de $W_{1,min}$ à $W_{1,max}$ ; et détermination de la constante de propagation $\beta_2(W_2)$ associée au mode fondamental supporté par le deuxième coupleur isolé du premier coupleur, en fonction de la largeur $W_2$ allant de $W_{2,pmin}$ à $W_{2,pmax}$ ;
- détermination de la variation longitudinale $\hat{W}_2 = \hat{f}_2(z)$ entre les positions $z_0$ et $z_f$ d'une largeur dite provisoire $\hat{W}_2$ du deuxième coupleur, pour laquelle l'écart entre les constantes de propagation $\beta_1(W_1)$ et $\beta_2(W_2)$ déterminées est nul ;
- détermination de la variation longitudinale des constantes de propagation $\beta_e$ et $\beta_o$ à partir de la variation longitudinale $W_1 = f_1(z)$ définie préalablement et de la variation longitudinale $\hat{W}_2 = \hat{f}_2(z)$ déterminée préalablement.

Le procédé de fabrication peut comporter les étapes suivantes :

- détermination des constantes de propagation $\beta_e(W_1 ; W_2)$ et $\beta_o(W_1 ; W_2)$ en fonction de la largeur $W_1$ allant de $W_{1,min}$ à $W_{1,max}$ et de la largeur $W_2$ allant de $W_{2,pmin}$ à $W_{2,pmax}$ ;
- détermination de la variation longitudinale $\kappa = h(z)$ entre $z_o$ et $z_f$ en fonction des constantes de propagation $\beta_e(W_1 ; W_2)$ et $\beta_o(W_1 ; W_2)$ déterminées préalablement, pour laquelle, en chaque position z, l'écart entre $\beta_e(W_1(z) ; W_2)$ et $\beta_o(W_1(z) ; W_2)$ est minimal.

La variation longitudinale $W_1 = f_1(z)$ définie de la largeur $W_1$ peut être une fonction monotone, et la variation longitudinale $W_2 = f_2(z)$ déterminée de la largeur $W_2$ peut être une fonction non-monotone.

L'invention porte également sur un procédé de fabrication d'une source laser hybride comportant deux transformateurs de mode fabriqués par le procédé selon l'une quelconque des caractéristiques précédentes, dans lequel la source laser hybride comporte :

- un substrat support, comportant un guide d'onde dit intégré de largeur $W_2$ ;
- un plot semiconducteur, reposant sur le substrat support, comportant des puits quantiques situées dans un guide d'onde dit actif de largeur $W_1$, couplé adiabatiquement à un guide d'onde intégré par les transformateurs de mode ;
- chaque transformateur de mode étant formé d'un coupleur dit actif du guide d'onde actif, et un coupleur dit intégré du guide d'onde intégré.

le plot semiconducteur peut être réalisé en au moins un composé semiconducteur III-V, et le substrat support peut être réalisé à base de silicium.

la longueur L du transformateur de mode peut être inférieure à $100\mu m$.

Le coupleur du guide d'onde intégré peut présenter une épaisseur inférieure ou égale à 300nm.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

les figures 1A et 1B, déjà décrites, sont des vues schématiques et partielles, respectivement en vue de dessus et en coupe transversale, d'une source laser hybride selon un exemple de l'art antérieur, dans laquelle les coupleurs des transformateurs de mode présentent des variations longitudinales monotones et linéaires de leurs largeurs ;

la figure 2, déjà décrite, est une vue schématique et partielle, en coupe longitudinale, d'un transformateur de mode similaire à ceux illustrés sur les fig.1A et 1B, illustrant le transfert optique par couplage adiabatique d'un guide d'onde à l'autre ;

la figure 3 est une vue schématique et partielle, de dessus, d'un transformateur de mode obtenu selon un procédé de fabrication selon un mode de réalisation ;

la figure 4 est un organigramme d'un procédé de fabrication selon un premier mode de réalisation ;

la figure 5 est un organigramme d'un procédé de fabrication selon un deuxième mode de réalisation.

**EXPOSÉ DÉTAILLÉ DE MODES DE RÉALISATION PARTICULIERS**

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte sur un procédé de fabrication d'un transformateur de mode adiabatique, c'est-à-dire d'un transformateur de mode assurant le couplage adiabatique entre un premier guide d'onde et un deuxième guide d'onde. Pour cela, le transformateur de mode est formé d'un coupleur du premier guide d'onde et d'un coupleur du deuxième guide d'onde, les deux coupleurs étant superposés l'un à l'autre suivant un axe d'épaisseur orthogonal à un axe longitudinal. Le couplage adiabatique est obtenu par une variation longitudinale de la largeur de chacun des deux coupleurs du transformateur de mode, et donc par une variation longitudinale des constantes de propagation des modes fondamentaux de chacun des coupleurs isolés, de manière à transférer la puissance optique d'un guide d'onde d'entrée au guide d'onde de sortie.

La figure 3 est une vue schématique en coupe longitudinale d'un transformateur de mode 3 obtenu par le procédé de fabrication selon un mode de réalisation. Dans cet exemple, le transformateur de mode 3 est un transformateur de mode d'une source laser hybride similaire à celle décrite en référence aux fig.1A et 1B et à la fig.2.

On définit ici et pour la suite de la description un repère direct tridimensionnel orthogonal XYZ, où le plan XZ est un plan parallèle au plan du substrat support 20, l'axe Z étant orienté suivant l'axe longitudinal des coupleurs 1c, 2c du transformateur de mode 3, l'axe X étant orienté suivant la largeur des coupleurs 1c, 2c, et où l'axe Y est orienté du substrat support 20 vers le plot semiconducteur 10 de la source laser 4 (cf. fig.1A et 1B).

La source laser 4 est ici de type DBR (*Distributed Bragg Reflector,* en anglais), mais l'invention s'applique également à une source laser de type DFB, voire à d'autres types de source laser (cavité en anneau par ex.). La source laser 4 comporte un plot semiconducteur 10 réalisé en au moins un composé semiconducteur de type III-V et disposé sur un substrat support 20 ici de type SOI. La cavité optique est délimitée par deux réflecteurs optiques 24, ici des miroirs de Bragg, situés dans le guide d'onde intégré 2 disposé dans le substrat support 20.

Le plot semiconducteur 10 contient le milieu à gain 11, lequel est situé dans un premier guide d'onde dit actif 1. Il comporte une couche 11 contenant de multiples puits quantiques, par exemple réalisés en InGaAsP avec un maximum de gain par exemple centré sur la longueur d'onde $\lambda$ égale à 1310nm. La couche 11 de puits quantiques est encadrée suivant l'axe Y par des couches semiconducteurs 12.1, 12.2 dopées n et p, par exemple réalisées en InP. Aussi, le plot semiconducteur 10 comporte une jonction PIN qui s'étend dans le plan XZ. Le guide d'onde actif 1 comporte en chacune de ses extrémités longitudinales un coupleur 1c dit actif dont la largeur $W_1$ varie suivant l'axe longitudinal Z suivant une fonction fi prédéfinie, de préférence monotone.

Le substrat support 20 comporte un deuxième guide d'onde 2, dit intégré, appartenant à un circuit photonique intégré. Le substrat support 20 est de type SOI (*Silicon On Insulator,* en anglais), de sorte que le deuxième guide d'onde 2 comporte un coeur réalisé en silicium et une gaine réalisée en un oxyde de silicium. Dans cet exemple, le guide d'onde intégré 2 est de préférence un guide en arête formé d'une arête 22 (*rib,* en anglais) reposant suivant l'axe Y sur une base 21 (*slab,* en anglais). La largeur $W_2$ du guide d'onde intégré 2 est ici la largeur de l'arête 22 suivant l'axe X. Le guide d'onde intégré 2 est espacé du plot semiconducteur 10 par une couche 23 d'oxyde de silicium d'une épaisseur locale $e_{gap}$ de préférence constante (cf. fig.1B). Le guide d'onde intégré 2 comporte un coupleur 2c dit intégré disposé en regard (c'est-à-dire à la perpendiculaire) du coupleur actif 1c suivant l'axe d'épaisseur Y. La largeur $W_2$ du coupleur 2c varie suivant l'axe longitudinal Z.

Bien entendu, le guide d'onde intégré 2 peut en variante être un guide d'onde droit, c'est-à-dire un guide d'onde dont le coeur présente une largeur $W_2$ constante suivant l'axe d'épaisseur Y entre les couches d'oxyde de silicium inférieure et supérieure. Autrement dit, un guide d'onde droit ne comporte pas d'arête de largeur étroite $W_2$ en saillie vis-à-vis d'une base de plus grande largeur.

Le transformateur de mode 3 est ainsi formé d'un coupleur actif 1c et un coupleur intégré 2c, les deux coupleurs 1c, 2c étant superposés l'un à l'autre suivant l'axe Y. Ils sont orientés suivant le même axe longitudinal Z.

Le guide d'onde actif 1 comporte une portion principale 1.1 à largeur constante suivant l'axe longitudinal, non couplée au guide d'onde intégrée 2, et située entre les transformateurs de mode 3 (cf. fig.1A). Il comporte ici une portion intercalaire 1.2, non couplée au guide d'onde intégré 2, et située entre la portion principale 1.1 et le coupleur actif 1c, dont la largeur varie ici de manière monotone et linéaire suivant l'axe longitudinal Z. Il comporte enfin le coupleur actif 1c, dont la largeur $W_1$ varie ici suivant une fonction fi définie, ici monotone et linéaire, entre une valeur maximale $W_{1,max}$ en la position zo et une valeur minimale $W_{1,min}$ en la position $z_f$. La longueur entre les positions $z_0$ et $z_f$ définit la longueur L du transformateur de mode 3. Cette longueur est choisie de manière à maximiser l'efficacité de couplage entre les deux guides d'onde 1, 2. Comme décrit plus loin, elle sera avantageusement optimisée. A titre d'exemple, la portion principale 1.1 peut présenter une largeur constante de $4\mu m$ environ, la portion intercalaire 1.2 une largeur passant de $4\mu m$ à $1\mu m$ environ sur une longueur de $45\mu m$ environ, et le coupleur actif 1c peut présenter une valeur maximale $W_{1,max}$ égale à $1\mu m$ environ, une valeur minimale $W_{1,min}$ de $0.5\mu m$ environ et une longueur L égale à $65\mu m$ environ.

Le guide d'onde intégré 2 présente une portion principale 2.1 à largeur constante, non couplée au guide d'onde actif 1, et située ici à distance du guide d'onde actif 1, et un coupleur intégré 2c dont la largeur $W_2$ présente une variation longitudinale $f_2(z)$ déterminée par le procédé de fabrication décrit plus loin. La largeur $W_2$ du coupleur intégré 2c varie ici de manière non monotone entre une valeur maximale $W_{2,max}$ en la position $z_f$ et une valeur minimale $W_{2,min}$ en la position $z_0$. Dans cet exemple, le guide d'onde intégré 2 comporte une portion intercalaire 2.2 à largeur constante égale ici à $W_{2,min}$ qui s'étend longitudinalement de manière à relier continûment les deux coupleurs intégrés 2c de la source laser 4. La valeur minimale $W_{2,min}$ est ici égale à $0.75\mu m$ environ et la valeur maximale $W_{2,max}$ est égale à $2.5\mu m$ environ. La base 21 peut présenter une largeur constante de $10\mu m$ environ et une épaisseur de 150nm à 200nm environ. L'arête 22 peut présenter une épaisseur de 100nm à 150nm environ (par ex. 150 nm pour la base et 150nm pour l'arête, ou 200nm pour la base et 100nm pour l'arête). L'espacement $e_{gap}$ en oxyde de silicium entre l'arête 22 et le plot semiconducteur 10 peut être égal à 100nm environ.

Comme décrit plus loin, il apparaît que la non-monotonie de la variation longitudinale d'au moins l'un des deux coupleurs 1c, 2c du transformateur de mode 3 (ici celle du coupleur intégré 2c), lorsqu'elle tient compte de la variation longitudinale de la largeur de l'autre coupleur pour vérifier un critère d'adiabaticité décrit plus loin, permet d'améliorer les performances optiques du transformateur de mode 3. En effet, comme décrit en détail plus loin, il apparaît que la longueur L d'un tel transformateur de mode 3 permettant d'obtenir une efficacité de couplage donné (par exemple 80%, voire 90%) est réduite, ce qui permet de faciliter l'obtention d'une source laser monomode (FSR plus élevé). Il apparaît également qu'un tel transformateur de mode présente une sensibilité réduite de l'efficacité de couplage aux variations de la longueur d'onde autour de la longueur d'onde d'intérêt $\lambda$. Un tel transformateur de mode présente de plus une efficacité de couplage dont la sensibilité est réduite aux variations d'espacement $e_{gap}$ entre le guide d'onde intégré et le plot semiconducteur. Un tel transformateur de mode permet de coupler un guide d'onde actif à un guide d'onde intégré qui présente une épaisseur de 300nm environ (épaisseur de 150nm environ pour la base et de 150nm environ pour l'arête). Un tel transformateur de mode 3 se distingue ainsi structurellement de ceux décrits dans l'article de Duan et al. 2014 mentionné précédemment, dans lesquels les coupleurs actif et intégré présentent une variation monotone et linéaire de leur largeur. Il n'est de plus pas nécessaire de réaliser un guide d'onde intégré de 500nm environ, comme dans Duan et al. 2014, pour assurer le couplage optique au guide d'onde actif. Dans Duan et al. 2014, en partant d'un substrat SOI de 300nm de silicium, il est nécessaire de réaliser une arête d'une épaisseur de 200nm environ sur la base de 300nm d'épaisseur. Il se distingue également de celui décrit dans l'article de Sun et al. intitulé Adiabaticity criterion and the shortest adiabatic mode transformer in a coupled-waveguide system Opt. Lett., 34, 280 (2009), dans lequel le transformateur de mode comporte un premier coupleur de largeur constante et un deuxième coupleur dont la largeur varie longitudinalement.

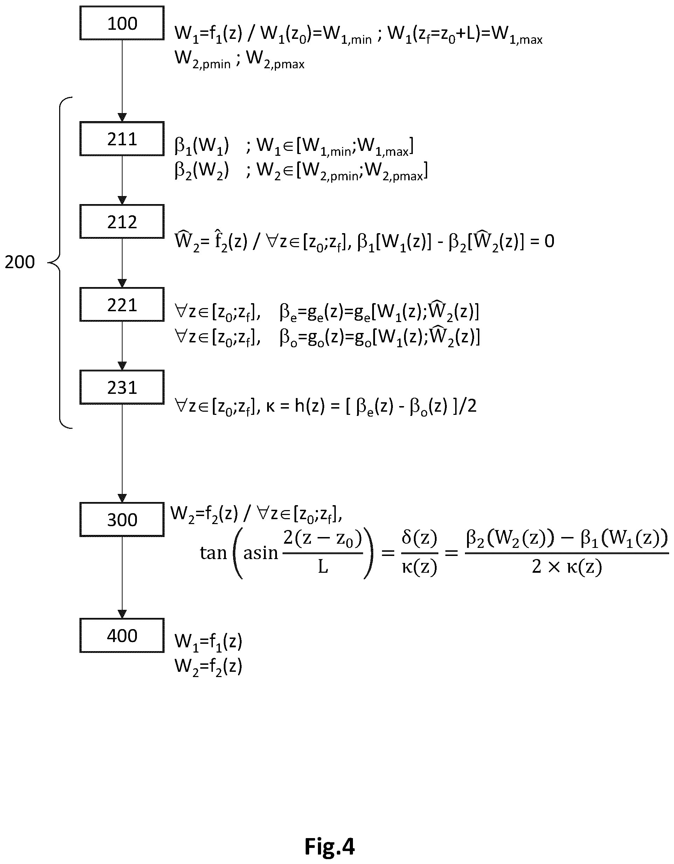

Le figure 4 est un organigramme illustrant certaines étapes d'un procédé de fabrication d'un transformateur de mode 3, similaire à celui illustré sur la fig.3, selon un premier mode de réalisation.

Lors d'une première étape 100, on définit des caractéristiques du transformateur de mode pour lequel la variation longitudinale $W_2=f_2(z)$ du coupleur intégré 2c du guide d'onde intégré 2 est à déterminer.

Concernant le guide d'onde actif 1, on définit ainsi l'indice de réfraction des matériaux qui le composent ainsi que les dimensions du coupleur actif 1c. Ainsi, le coeur (couche de puits quantiques) peut être réalisé en InGaAsP, et la gaine (couches inférieure et supérieure encadrant la couche de puits quantiques) peut être réalisée en InP. On définit également l'épaisseur du coeur et de la gaine. Enfin, on définit la variation longitudinale $W_1=f_1(z)$ de la largeur $W_1$ du coupleur actif 1c, entre la valeur maximale $W_{1,max}$ à la position zo et la valeur minimale $W_{1,min}$ à la position $z_f$. On définit également la longueur L du coupleur actif 1c, qui correspond alors à celle du transformateur de mode 3. A titre d'exemple, la valeur minimale $W_{1,min}$ peut être choisie en fonction des contraintes de réalisation des pointes des guides d'onde, et peut être égale à $0.5\mu m$ environ. La valeur maximale $W_{1,max}$ peut être égale par exemple à $1\mu m$ environ. La longueur L peut être égale à $65\mu m$ environ.

Concernant le guide d'onde intégré 2, on définit les indices de réfraction des matériaux qui le compose (silicium, oxyde de silicium), l'épaisseur du guide d'onde intégré 2 ou au moins du coupleur 2c, et des valeurs provisoires minimale $W_{2,pmin}$ et maximale $W_{2,pmax}$. Ces valeurs sont dites provisoires dans la mesure où elles ne correspondent pas nécessairement aux valeurs effectives minimale $W_{2,min}$ en zo et maximale $W_{2,max}$ en $z_f$ de la largeur $W_2$ lorsque sa variation longitudinale $W_2=f_2(z)$ sera déterminée. Il s'agit ici des valeurs définissant le domaine sur lequel seront calculées les différentes constantes de propagation, ici les constantes de propagation $\beta_1$ et $\beta_2$ des modes fondamentaux des coupleurs isolés 1c, 2c. A titre d'exemple, la valeur minimale $W_{2,pmin}$ peut être égale à $0.5\mu m$, et la valeur maximale $W_{2,pmax}$ peut être par exemple supérieure ou égale à $W_{1,max}$, par exemple égale à $1.5\mu m$. La valeur $W_{2,pmax}$ peut être comprise entre $0.2\mu m$ et $3\mu m$ environ.

Rappelons ici que les guides d'onde isolés 1, 2, c'est-à-dire non couplés l'un à l'autre, se caractérisent notamment par les constantes de propagation $\beta_1$, $\beta_2$ associés respectivement aux modes fondamentaux supportés par les deux guides d'onde isolés 1, 2. On peut donc calculer le paramètre $\delta$ de désaccord de phase (*phase mismatch parameter*, en anglais) tel que $\delta=(\beta_1-\beta_2)/2$. Par ailleurs, le système couplé formé des deux guides d'onde 1, 2 couplés l'un à l'autre se caractérise également par les constantes de propagation $\beta_e$, $\beta_o$ associés respectivement aux supermodes pair $E_e$ et impair $E_o$, ainsi que par le paramètre de couplage $\kappa$. Ce paramètre $\kappa$ représente la force de couplage entre les deux guides d'onde 1, 2. Autrement dit, il correspond d'une certaine manière au taux de recouvrement, dans le système couplé, de la distribution spatiale de l'amplitude des champs électriques $E_1$, $E_2$ des modes fondamentaux des guides d'onde isolés 1, 2. Comme l'indique notamment l'article de Sun & Yariv intitulé Engineering supermode silicon/III-V hybrid waveguides for laser oscillation, J. Opt. Soc. Am. B, Vol. 25, No. 6, 923 (2008), le paramètre de couplage $\kappa$ dépend de la distribution spatiale dans le plan XY des indices de réfraction des guides d'onde isolés 1, 2 et de celui du système couplé, ainsi que de la distribution spatiale de l'amplitude des champs électriques $E_1$, $E_2$ des modes fondamentaux supportés par les deux guides d'onde isolés 1, 2. Par ailleurs, comme défini dans l'article de Sun et al. 2009 mentionné précédemment, lorsque seul le supermode pair $E_e$ est excité, le paramètre S relie les constantes de propagation $\beta_e$ et $\beta_o$ et les paramètres $\delta$ et $\kappa$ par la relation : $S=(\beta_e-\beta_o)/2=(\delta^2+\kappa^2)^{1/2}$.

Lors d'une étape 200 suivante, on détermine la variation longitudinale $\kappa=h(z)$ du paramètre de couplage $\kappa$ entre la position zo et la position $z_f$. Dans ce premier mode de réalisation, on détermine pour cela la variation longitudinale $\hat{W}_2=\hat{f}_2(z)$ d'une largeur provisoire $\hat{W}_2$ du coupleur intégré 2c pour laquelle l'écart $\beta_1[W_1(z)]-\beta_2[\hat{W}_2(z)]$ est localement nul entre les constantes de propagation $\beta_1$, $\beta_2$ des modes isolés. Cette largeur $\hat{W}_2(z)$ est dite provisoire dans la mesure où elle est différente de la largeur effective $W_2=f_2(z)$ du coupleur 2c du guide d'onde intégré 2 lorsque le critère d'adiabaticité sera vérifié (étape 300 détaillée plus loin). Dans cette étape 200, la constante de propagation $\beta_2$ du mode fondamental supporté par le coupleur intégré isolé 2c est calculée sur la base de cette largeur provisoire $\hat{W}_2(z)$.

Pour cela, dans une sous-étape 211, on calcule la constante de propagation $\beta_1$ en fonction de la largeur $W_1$ dans le domaine de calcul $[W_{1,min} ; W_{1,max}]$. Par constante de propagation, on entend la constante de propagation $\beta_1$ proprement dite ou un paramètre équivalent tel que l'indice effectif $n_{eff,1}$ du mode fondamental dans le guide d'onde isolé. On calcule également la valeur de la constante de propagation $\beta_2$ en fonction de la largeur $W_2$ dans le domaine de calcul $[W_{2,pmin} ; W_{2,pmax}]$. Cette étape peut être effectuée par un solveur de mode de type à éléments finis (*FEM mode solver,* en anglais).

Ensuite, dans une sous-étape 212, on détermine la variation longitudinale $\hat{W}_2=\hat{f}_2(z)$ (z) de la largeur provisoire $\hat{W}_2$ pour laquelle l'écart $\beta_1[W_1(z)]-\beta_2[/\hat{W}_2(z)]$ est localement nul en chaque position z entre zo et $z_f$. Pour cela, une approche consiste à déterminer, pour chaque valeur de la largeur $W_1$ entre $W_{1,min}$ et $W_{1,max}$ et donc pour chaque position z entre zo et $z_f$, la valeur de la largeur dite alors provisoire $\hat{W}_2(z)$ pour laquelle l'écart $\beta_1[W_1(z)]-\beta_2[\hat{W}_2(z)]$ est localement nul (par interpolation). On obtient ainsi la variation longitudinale $\hat{W}_2=\hat{f}_2(z)$ entre zo et $z_f$. En d'autres termes, cela revient à déterminer la valeur de la largeur provisoire $\hat{W}_2$ du coupleur intégré 2c, en chaque position z comprise entre zo et $z_f$, pour laquelle il y a localement anti-croisement (*anti-crossing,* en anglais) entre les modes fondamentaux supportés par les coupleurs actif 1c et intégré 2c isolés.

Ensuite, dans une sous-étape 221, on calcule la variation longitudinale $\beta_e=g_e(z)$, entre zo et $z_f$, de la constante de propagation $\beta_e$ du supermode pair $E_e$, ainsi que la variation longitudinale $\beta_o=g_o(z)$ entre zo et $z_f$ de la constante de propagation $\beta_o$ du supermode impair $E_o$, en fonction de la variation longitudinale $W_1=f_1(z)$ de la largeur $W_1$ du coupleur actif 1c et de la variation longitudinale $\hat{W}_2=\hat{f}_2(z)$ de la largeur provisoire $\hat{W}_2$ du guide intégré 2c. Autrement dit, la constante de propagation $\beta_e$ du supermode pair est fonction, en chaque position z, des largeurs correspondantes $W_1(z)$ et $\hat{W}_2(z)$ déterminées : $\beta_e=g_e(z)=g_e[W_1(z) ; \hat{W}_2(z)]$. De manière similaire, on a : $\beta_o=g_o(z)=g_o[W_1(z) ; \hat{W}_2(z)]$. Les constantes de propagation $\beta_e$, $\beta_o$ peuvent être calculées par un solveur de mode de type à éléments finis.

Enfin, dans une sous-étape 231, on calcule la variation longitudinale $\kappa=h(z)$, entre zo et $z_f$, du paramètre de couplage $\kappa$ à partir des variations longitudinales déterminées $\beta_e=g_e(z)$ et $\beta_o=g_o(z)$ des constantes de propagation $\beta_e$, $\beta_o$. D'une manière connue, le paramètre de couplage $\kappa$ est relié aux constantes de propagation $\beta_e$, $\beta_o$ par le paramètre S : $S = (\beta_e-\beta_o)/2=(\hat{\delta}^2+\kappa^2)^{1/2}$. Le paramètre $\hat{\delta}$ est défini comme correspondant à l'écart entre les constantes de propagation $\beta_1[W_1(z)]$ et $\beta_2[\hat{W}_2(z)]$ déterminées à partir de la largeur locale $W_1(z)$ et de la largeur provisoire locale $\hat{W}_2(z)$. Or, ce paramètre $\hat{\delta}$ est localement nul pour toute position z entre zo et $z_f$ du fait du choix de la largeur provisoire locale $\hat{W}_2(z)$. Aussi, le paramètre de couplage $\kappa$ se calcule aisément en toute position z entre zo et $z_f$ par la relation : $\kappa(z)=[\beta_e(z) - \beta_o(z)]/2$. On obtient ainsi la variation longitudinale $\kappa=h(z)$ du paramètre de couplage $\kappa$ pour laquelle il y a localement, en toute position de z suivant l'axe longitudinal, égalité entre les constantes de propagation $\beta_1$, $\beta_2$ des modes fondamentaux supportés par les deux coupleurs isolés 1c, 2c.

Lors d'une étape 300 suivante, on détermine la variation longitudinale $W_2=f_2(z)$ de la largeur $W_2$ pour laquelle le critère d'adiabaticité est vérifié (minimisation des pertes optiques). Ce critère, bien connu de l'homme du métier, est identique ou similaire à celui décrit dans l'article de Sun et al. 2009 mentionné précédemment. Il relie ici l'écart de la position z considérée à la position de référence zo, adimensionné par la longueur L du transformateur de mode 3, aux valeurs locales des paramètres $\delta(z)$ et $\kappa(z)$. Ici, le paramètre $\delta(z)$ dépend notamment de la largeur $W_2(z)$ à déterminer du coupleur intégré. Le critère d'adiabaticité s'écrit ici :

$$\forall z \in [z_0 \; ; \; z_f], \quad \tan\left(\operatorname{asin}\left(2 \times \frac{z-z_0}{L}\right)\right) = \frac{\delta(z)}{\kappa(z)} = \frac{\beta_1(W_1(z)) - \beta_2(W_2(z))}{2 \times \kappa(z)}$$

La résolution de cette équation paramétrique permet ainsi d'obtenir la variation longitudinale $W_2 = f_2(z)$ de la largeur $W_2$ pour laquelle le critère d'adiabaticité est vérifié. Comme le décrit l'article de Sun et al. 2009, ce critère revient à exciter principalement le supermode pair $E_e$ et non pas le supermode impair $E_o$. Aussi, le supermode pair $E_e$ assure le transfert de la puissance optique d'un guide d'onde à l'autre par couplage adiabatique (comme l'illustre la fig.2). Cependant, ce critère d'adiabaticité diffère de celui exprimé par Sun et al. 2009 en ce que le paramètre de couplage $\kappa(z)$ a été déterminé préalablement de sorte qu'il y ait anti-croisement en toute position z entre zo et $z_f$. Aussi, la variation longitudinale $W_2 = f_2(z)$ du coupleur intégré 2c tient compte de celle du coupleur actif 1c. On note ici que cette variation longitudinale $W_2 = f_2(z)$ est différente de la variation longitudinale $\hat{W}_2 = \hat{f}_2(z)$ déterminée préalablement, pour laquelle l'anti-croisement entre les modes isolés est localement vérifié.

Lors d'une étape 400 suivante, on réalise ensuite le transformateur de mode 3 entre le guide d'onde actif 1 et le guide d'onde intégré 2 à partir de la variation longitudinale $W_1 = f_1(z)$ de la largeur $W_1$ du coupleur actif 1c et de la variation longitudinale $W_2 = f_2(z)$ de la largeur $W_2$ du coupleur intégré 2c. Il apparaît que la variation longitudinale $W_2 = f_2(z)$ déterminée est non-monotone entre zo et $z_f$. Cette non-monotonie de la fonction $f_2$ qui tient compte de la variation longitudinale $f_1$ de la largeur $W_1$ du coupleur actif 1c permet d'améliorer les performances du transformateur de mode 3.

Ainsi, le procédé selon l'invention permet d'obtenir une longueur L réduite du transformateur de mode 3 pour une même efficacité de couplage comparé à un transformateur de mode tel que décrit par Sun et al. 2009 où l'un des coupleurs est un guide d'onde droit (pas de variation longitudinale de sa largeur). A titre d'exemple, pour une longueur de $100\,\mu m$ d'un transformateur de mode décrit par Sun et al. 2009 permettant d'obtenir une efficacité de couplage de 95%, le procédé selon l'invention permet d'obtenir une même efficacité de couplage pour une longueur L réduite de transformateur de mode 3, par exemple $75\,\mu m$. La réduction de la longueur du transformateur de mode 3 permet d'obtenir un paramètre FSR (*Free Spectral Range,* en anglais) plus élevé, ce qui facilite l'obtention du caractère monomode de la source laser.

Par ailleurs, il apparaît que le procédé selon l'invention permet d'obtenir un transformateur de mode 3 présentant une sensibilité réduite aux variations de la longueur d'onde autour de la longueur d'onde d'intérêt $\lambda$, par exemple 1310nm. En effet, un transformateur de mode tel que décrit par Sun et al. 2009 présente une forte diminution de l'efficacité de couplage à mesure que l'on s'écarte de la longueur d'onde d'intérêt $\lambda$, par exemple entre 1260nm et 1340nm, alors que le transformateur de mode 3 obtenu par le procédé selon l'invention présente une efficacité de couplage sensiblement constante sur une telle plaque de longueur d'onde centrée autour de 1310nm.

Il apparaît également que, comparé à un transformateur de mode tel que décrit par Sun et al. 2009, le transformateur de mode 3 obtenu par le procédé selon l'invention présente une sensibilité réduite à l'espacement $e_{gap}$ défini par la couche de gaine (couche d'oxyde 23 ici) entre le plot semiconducteur 10 et le guide d'onde intégré 2. A titre d'exemple, pour un guide d'onde intégré 2 en arête de 500nm d'épaisseur (base de 300nm d'épaisseur et arête de 200nm d'épaisseur), l'efficacité de couplage présente une valeur maximale de 95% environ pour $e_{gap}$ égal à 100nm environ. Or, l'efficacité de couplage chute entre 88% et 80% environ lorsque $e_{gap}$ est égal respectivement à 80nm environ et à 120nm environ. En revanche, un transformateur de mode 3 obtenu par le procédé selon l'invention permet d'obtenir une efficacité de couplage sensiblement constante pour $e_{gap}$ compris entre 80nm et 120nm, par exemple supérieure ou égale à 90% pour un guide d'onde intégré en arête de 300nm (par ex. base de 150nm d'épaisseur et arête de 150nm d'épaisseur). Il en ressort donc également qu'un guide d'onde intégré 2 d'épaisseur plus fine permet d'obtenir une efficacité de couplage élevée. Il n'est en effet pas nécessaire de réaliser un guide d'onde intégré en arête de 500nm environ comme dans les exemples de l'art antérieur mentionnés précédemment (Duan et al. 2014 ; Sun & Yariv 2008). On simplifie ainsi le procédé de fabrication du transformateur de mode.

La longueur L du transformateur de mode 3 peut être avantageusement optimisée. Pour cela, on cherche à déterminer la longueur L minimale permettant d'obtenir une efficacité de couplage donnée, par exemple 80% ou 90%, voire davantage. Le procédé de fabrication comporte une sous-étape 310, effectuée à la suite de l'étape 300, dans laquelle on calcule l'efficacité de couplage pour la longueur L du transformateur de mode 3. Comme mentionné précédemment, l'efficacité de couplage correspond au rapport $P_{out}/P_{in}$ entre la puissance optique $P_{out}$ du mode fondamental du faisceau de sortie sur celle $P_{in}$ du faisceau incident. L'optimisation comporte la réitération des étapes 100 à 310 pour différentes valeurs de la longueur L. Lorsque le taux de variation de l'efficacité de couplage en fonction de L est inférieure ou égale à un seuil prédéfini, on choisit la longueur L correspondante. Il s'agit ainsi de la plus petite longueur L pour laquelle l'efficacité de couplage ne varie sensiblement plus. Comme mentionné précédemment, il apparaît que la longueur L optimisée présente une valeur réduite comparée à celle d'un transformateur de mode adiabatique tel que décrit par Sun et al. 2009.

Notons également que le procédé de fabrication selon l'invention diffère de celui décrit dans l'article de Duprez et al. 2015 mentionné précédemment, en ce que, dans la démarche de cet article, le paramètre de couplage $\kappa$ est une

constante calculée au point, appelé zo, où l'accord de phase est obtenu : $\delta_{z0}$=0 et $\kappa_{z0}$=($\beta_e$-$\beta_o$)/2, et est supposée constante sur toute la longueur du transformateur de mode. Dans le procédé selon l'invention, au contraire, le paramètre de couplage $\kappa$ est défini, lors de l'étape 200, sur toute la gamme de valeurs entre $W_{1,min}$ et $W_{1,max}$ d'une part, et entre les valeurs provisoires $W_{2,pmin}$ et $W_{2,pmax}$ d'autre part. Ensuite, pour chaque valeur locale de $W_1$ (et donc de z), on cherche quelle est la valeur locale $\hat{W}_2(W_1)$ (et donc $\hat{W}_2(z)$) pour laquelle on a l'égalité entre des constantes de propagation $\beta_1$ et $\beta_2$. On obtient alors une valeur du paramètre de couplage $\kappa$ pour chaque valeur $W_1$ dont la variation a été prédéfinie (et donc pour chaque position z). Cette variation $\kappa(W_1)$ et donc $\kappa(z)$ permet alors de définir la largeur $W_2$ du deuxième coupleur à partir du critère d'adiabaticité (étape 300).

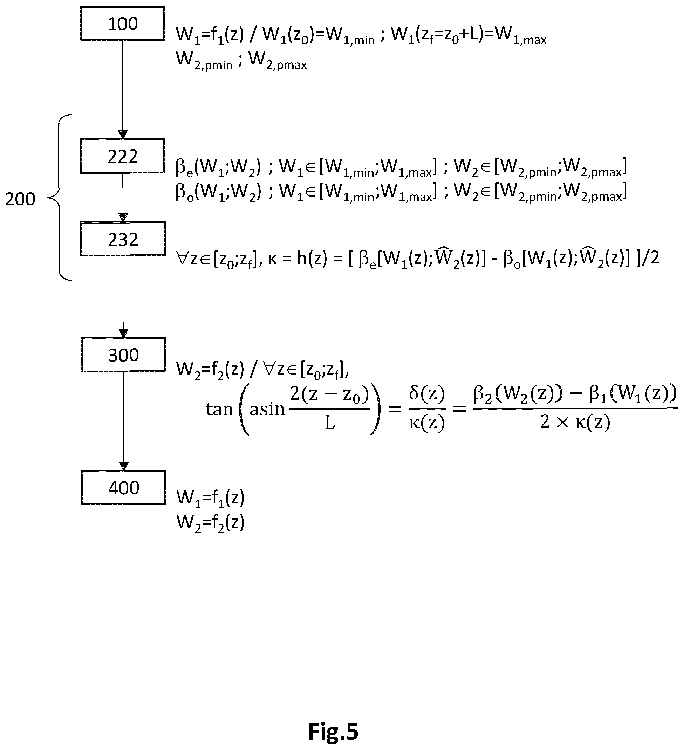

La figure 5 est un organigramme d'un procédé de fabrication d'une source laser hybride 4 selon un deuxième mode de réalisation. Ce procédé se distingue de celui décrit en référence à la fig.4 essentiellement par la manière de déterminer la variation longitudinale $\kappa$=h(z) du paramètre de couplage $\kappa$. Plus précisément, la variation longitudinale $\kappa$=h(z) est ici déterminée sans passer par un calcul explicite de la variation longitudinale $\hat{W}_2=\hat{f}_2(z)$ de la largeur provisoire $\hat{W}_2$ pour laquelle il y a égalité entre les constantes de propagation $\beta_1[W_1(z)]$ et $\beta_2[\hat{W}_2(z)]$.

La première étape 100 consiste à définir certaines caractéristiques du transformateur de mode, en particulier sa longueur L, la variation longitudinale $W_1$=$f_1$(z) de la largeur $W_1$ du coupleur actif 1c entre les positions zo et $z_f$, et les valeurs provisoires $W_{2,pmin}$, $W_{2,pmax}$ relatives au coupleur intégré 2c. Cette étape est identique ou similaire à celle décrite en référence à la fig.4 et n'est pas détaillée à nouveau.

Dans une étape 200 suivante, on détermine la variation longitudinale $\kappa$=h(z) du paramètre de couplage $\kappa$ entre les positions zo et $z_f$. Dans ce deuxième mode de réalisation, on ne calcule pas de manière explicite la variation longitudinale $\hat{W}_2=\hat{f}_2(z)$ du coupleur intégré 2c, mais celle-ci est obtenue de manière implicite.

Pour cela, dans une sous-étape 222, on calcule les constantes de propagation $\beta_e$ et $\beta_o$ en fonction d'une part de la largeur $W_1$ du coupleur actif 1c et d'autre part de la largeur $W_2$ du coupleur intégré 2c. Autrement dit, on calcule $\beta_e(W_1;W_2)$ et $\beta_o(W_1;W_2)$ dans le domaine de calcul défini par les valeurs minimales et maximales définies dans l'étape 100, c'est-à-dire dans le domaine de calcul :

$$W_1 \in [W_{1,min} \; ; \; W_{1,max}] \text{ et } W_2 \in [W_{2,pmin} \; ; \; W_{2,pmax}].$$

Ensuite, dans une sous-étape 232, on calcule, pour chaque valeur de la largeur $W_1$ entre $W_{1,min}$ et $W_{1,max}$, donc pour chaque position z entre zo et $z_f$ (via la fonction $W_1$=$f_1$(z)), la valeur $\hat{W}_2(z)$ de $W_2$ pour laquelle l'écart $\Delta\beta_{eo}$=$\beta_e$-$\beta_o$ est minimal. Autrement dit, la valeur $\hat{W}_2(z)$ est telle que, pour $W_1(z)$ considéré, on a $\beta_e(W_1(z); \hat{W}_2)$ - $\beta_o(W_1(z); \hat{W}_2)$ = min[$\beta_e(W_1(z);W_2)$ - $\beta_o(W_1(z);W_2)$]. On obtient ainsi la variation longitudinale $\kappa$=h(z) du paramètre de couplage $\kappa$ entre les positions $z_0$ et $z_f$, par la relation : $\kappa$=h(z)= [ $\beta_e(W_1(z); \hat{W}_2(z))$ - $\beta_o(W_1(z); \hat{W}_2(z))$ ]/2.

Lors d'une étape 300 suivante, on détermine la variation longitudinale $W_2$=$f_2$(z) de la largeur $W_2$ pour laquelle le critère d'adiabaticité est vérifié. Cette étape est ici identique ou similaire à celle décrite précédemment en référence à la fig.4 et n'est donc pas détaillée à nouveau.

Lors d'une étape 400 suivante, on réalise ensuite le transformateur de mode 3 entre le guide d'onde actif et le guide d'onde intégré à partir de la variation longitudinale $W_1$=$f_1$(z) de la largeur $W_1$ du coupleur actif 1c et de la variation longitudinale $W_2$=$f_2$(z) de la largeur $W_2$ du coupleur intégré 2c. Le procédé selon ce deuxième mode de réalisation présente les mêmes avantages que ceux du procédé selon le premier mode de réalisation.

Des modes de réalisation particuliers viennent d'être décrits. Différentes variantes et modifications apparaîtront à l'homme du métier.

## Revendications

**1.** Procédé de fabrication d'un transformateur de mode (3) assurant le couplage adiabatique entre un premier guide d'onde (1) et un deuxième guide d'onde (2), le transformateur de mode (3) étant formé d'un premier coupleur (1c) du premier guide d'onde (1) et d'un deuxième coupleur (2c) du deuxième guide d'onde (2), les premier et deuxième coupleurs (1c, 2c) étant superposés l'un à l'autre et présentant une largeur variable, respectivement $W_1$ et $W_2$, sur une longueur L suivant un axe longitudinal, le procédé comportant les étapes suivantes :

     ◦ définition (100) d'une part d'une variation longitudinale $W_1$=$f_1$(z) de la largeur $W_1$ du premier coupleur (1c), entre des positions zo et $z_f$ suivant l'axe longitudinal telles que $z_f$=$z_0$+L, allant d'une valeur maximale $W_{1,max}$ en zo à une valeur minimale $W_{1,min}$ en $z_f$, et d'autre part de valeurs dites provisoires minimale $W_{2,pmin}$ et maximale $W_{2,pmax}$ de la largeur $W_2$ du deuxième coupleur (2c) ;
     ◦ détermination (221 ; 222) de constantes de propagation $\beta_e$ et $\beta_o$ associées respectivement à des supermodes pair et impair supportés par les deux coupleurs (1c, 2c), pour chaque position z entre zo et $z_f$, en fonction :

- de la valeur locale $W_1(z)$ en z de la largeur $W_1$ du premier coupleur (1c), et
- d'une valeur locale $\hat{W}_2(z)$ en z de la largeur $W_2$ du deuxième coupleur (2c),

  - pour laquelle il y a égalité entre des constantes de propagation $\beta_1(W_1(z))$ et $\beta_2(\hat{W}_2(z))$ associés respectivement aux modes fondamentaux supportés par le premier coupleur (1c) de largeur locale $W_1(z)$ et par le deuxième coupleur (2c) de largeur locale $\hat{W}_2(z)$, les deux coupleurs (1c, 2c) étant alors isolés l'un de l'autre ;

  ∘ détermination (231 ; 232) d'une variation longitudinale $\kappa=h(z)$ entre zo et $z_f$ du paramètre de couplage $\kappa$ entre les deux coupleurs (1c, 2c), à partir d'une différence entre les constantes de propagation $\beta_e$ et $\beta_o$ déterminées ;
  ∘ détermination (300) d'une variation longitudinale $W_2=f_2(z)$ entre zo et $z_f$ de la largeur $W_2$ du deuxième coupleur (2c) de telle sorte que le critère d'adiabaticité est vérifié à chaque position z, ce critère d'adiabaticité reliant la position z considérée, la longueur L prédéfinie, le paramètre de couplage $\kappa(z)$ prédéterminé, ladite constante de propagation $\beta_1(W_1(z))$, et une constante de propagation $\beta_2(W_2(z))$ associée à une valeur locale $W_2(z)$ à déterminer ;
  ∘ fabrication (400) du transformateur de mode (3), dans lequel le premier coupleur (1c) présente la variation longitudinale $W_1=f_1(z)$ définie, et le deuxième coupleur (2c) présente la variation longitudinale $W_2=f_2(z)$ déterminée.

2. Procédé de fabrication selon la revendication 1, comportant :

   ∘ à la suite de l'étape de détermination de la variation longitudinale $W_2=f_2(z)$, une étape de détermination (310) d'une efficacité de couplage définie comme le rapport $P_{out}/P_{in}$ entre un paramètre représentatif d'une puissance optique $P_{out}$ d'un mode fondamental en sortie du transformateur de mode (3) et un paramètre représentatif d'une puissance optique $P_{in}$ d'un mode fondamental en entrée du transformateur de mode (3),
   ∘ réitération des étapes allant de l'étape de définition à l'étape de détermination de l'efficacité de couplage, pour différentes valeurs de la longueur L ;
   ∘ détermination d'une valeur minimale de la longueur L pour laquelle la variation de l'efficacité de couplage en fonction de la longueur L est inférieure ou égale à un seuil prédéfini.

3. Procédé de fabrication selon la revendication 1 ou 2, comportant avant l'étape de détermination de constantes de propagation $\beta_e$ et $\beta_o$ les étapes suivantes :

   ∘ détermination (211) de la constante de propagation $\beta_1(W_1)$ associée au mode fondamental suppoerté par le premier coupleur (1c) isolé du deuxième coupleur (2c), en fonction de la largeur $W_1$ allant de $W_{1,min}$ à $W_{1,max}$ ; et détermination de la constante de propagation $\beta_2(W_2)$ associée au mode fondamental supporté par le deuxième coupleur (2c) isolé du premier coupleur (1c), en fonction de la largeur $W_2$ allant de $W_{2,pmin}$ à $W_{2,pmax}$ ;
   ∘ détermination (212) de la variation longitudinale $\hat{W}_2=\hat{f}_2(z)$ entre les positions zo et $z_f$ d'une largeur dite provisoire $\hat{W}_2$ du deuxième coupleur (2c), pour laquelle l'écart entre les constantes de propagation $\beta_1(W_1)$ et $\beta_2(W_2)$ déterminées est nul ; et dans lequel l'étape de détermination de constantes de propagation $\beta_e$ et $\beta_o$ comporte la détermination (221) de la variation longitudinale des constantes de propagation $\beta_e$ et $\beta_o$ à partir de la variation longitudinale $W_1=f_1(z)$ définie préalablement et de la variation longitudinale $\hat{W}_2=\hat{f}_2(z)$ déterminée préalablement.

4. Procédé de fabrication selon la revendication 1 ou 2, dans lequel les étapes de détermination des constantes de propagation $\beta_e$ et $\beta_o$ et de détermination de la variation longitudinale $\kappa=h(z)$ comporte les étapes suivantes :

   ∘ détermination (222) des constantes de propagation $\beta_e(W_1 ;W_2)$ et $\beta_o(W_1 ;W_2)$ en fonction de la largeur $W_1$ allant de $W_{1,min}$ à $W_{1,max}$ et de la largeur $W_2$ allant de $W_{2,pmin}$ à $W_{2,pmax}$ ;
   ∘ détermination (232) de la variation longitudinale $\kappa=h(z)$ entre zo et $z_f$ en fonction des constantes de propagation $\beta_e(W_1 ;W_2)$ et $\beta_o(W_1 ;W_2)$ déterminées préalablement, pour laquelle, en chaque position z, l'écart entre $\beta_e(W_1(z) ;W_2)$ et $\beta_o(W_1(z) ;W_2)$ est minimal.

5. Procédé de fabrication selon l'une quelconque des revendications 1 à 4, dans lequel la variation longitudinale $W_1=f_1(z)$ définie de la largeur $W_1$ est une fonction monotone, et dans lequel la variation longitudinale $W_2=f_2(z)$ déterminée de la largeur $W_2$ est une fonction non-monotone.

6. Procédé de fabrication d'une source laser hybride (4) comportant deux transformateurs de mode (3) fabriqués par le procédé selon l'une quelconque des revendications précédentes, dans lequel la source laser hybride (4) comporte :

◦ un substrat support (20), comportant un guide d'onde dit intégré (2) de largeur $W_2$ ;

◦ un plot semiconducteur (10), reposant sur le substrat support (20), comportant des puits quantiques (11) situées dans un guide d'onde dit actif (1) de largeur $W_1$, couplé adiabatiquement à un guide d'onde intégré (2) par les transformateurs de mode (3) ;

◦ chaque transformateur de mode (3) étant formé d'un coupleur dit actif (1c) du guide d'onde actif (1), et un coupleur dit intégré (2c) du guide d'onde intégré (2).

7. Procédé de fabrication selon la revendication 6, dans lequel le plot semiconducteur est réalisé en au moins un composé semiconducteur III-V, et le substrat support est réalisé à base de silicium.

8. Procédé de fabrication selon la revendication 6 ou 7, dans lequel la longueur L du transformateur de mode est inférieure à $100\mu$m.

9. Procédé de fabrication selon l'une quelconque des revendications 6 à 8, dans lequel le coupleur (2c) du guide d'onde intégré (3) présente une épaisseur inférieure ou égale à 300nm.

**Patentansprüche**

1. Verfahren zur Herstellung eines Modenwandlers (3), der die adiabatische Kopplung zwischen einem ersten Wellenleiter (1) und einem zweiten Wellenleiter (2) sicherstellt, wobei der Modenwandler (3) von einem ersten Koppler (1c) des ersten Wellenleiters (1) und einem zweiten Koppler (2c) des zweiten Wellenleiters (2) gebildet wird, wobei der erste und zweite Koppler (1c, 2c) übereinander gelagert sind und eine variable Breite, $W_1$ bzw. $W_2$, über eine Länge L entlang einer Längsachse aufweisen, wobei das Verfahren die folgenden Schritte aufweist:

◦ Festlegen (100), einerseits, einer Längsvariation $W_1=f_1(z)$ der Breite $W_1$ des ersten Kopplers (1c), zwischen Positionen $z_0$ und $z_f$ entlang der Längsachse, so dass $z_f=z_0+L$, von einem Maximalwert $W_{1,max}$ in $z_0$ zu einem Minimalwert $W_{1,min}$ in $z_f$, und andererseits von provisorischen Minimal- $W_{2,pmin}$ und Maximalwerten $W_{2,pmax}$ der Breite $W_2$ des zweiten Kopplers (2c) ;

◦ Bestimmen (221; 222) von Ausbreitungskonstanten $\beta_e$ und $\beta_o$, die jeweils geraden und ungeraden Supermoden zugeordnet sind, die von den zwei Kopplern (1c, 2c) getragen werden, für jede z-Position zwischen $z_0$ und $z_f$ in Abhängigkeit von:

• dem lokalen Wert $W_1(z)$ in z der Breite $W_1$ des ersten Kopplers (1c), und
• einem lokalen Wert $\hat{W}_2(z)$ in z der Breite $W_2$ des zweiten Kopplers (2c),

- für welchen zwischen Ausbreitungskonstanten $\beta_1(W_1(z))$ et $\beta_2(\hat{W}(z))$, die jeweils den Grundmoden zugeordnet sind, die vom ersten Koppler (1c) mit einer lokalen Breite $W_1(z)$ und vom zweiten Koppler (2c) mit einer lokalen Breite $\hat{W}_2(z)$ getragen werden, Gleichheit vorliegt, wobei die zwei Koppler (1c, 2c) dann voneinander isoliert sind;

◦ Bestimmen (231; 232) einer Längsvariation $\kappa=h(z)$ zwischen $z_0$ und $z_f$ des Kopplungsparameters $\kappa$ zwischen den zwei Kopplern (1c, 2c) ausgehend von einer Differenz zwischen den bestimmten Ausbreitungskonstanten $\beta_e$ et $\beta_o$ ;

◦ Bestimmen (300) einer Längsvariation $W_2=f_2(z)$ zwischen $z_0$ und $z_f$ der Breite $W_2$ des zweiten Kopplers (2c), so dass das Adiabatizitätskriterium bei jeder z-Position überprüft wird, wobei dieses Adiabatizitätskriterium die betrachtete z-Position, die vorgegebene Länge L, den vorbestimmten Kopplungsparameter $\kappa(Z)$ , die Ausbreitungskonstante $\beta_1(W_1(z))$ und eine Ausbreitungskonstante $P_2(W_2(z))$, die einem zu bestimmenden lokalen Wert $W_2(z)$ zugeordnet ist, verbindet;

◦ Herstellen (400) des Modenwandlers (3), wobei der erste Koppler (1c) die festgelegte Längsvariation $W_1=f_1(z)$ und der zweite Koppler (2c) die bestimmte Längsvariation $W_2=f_2(z)$ aufweist.

2. Herstellungsverfahren nach Anspruch 1, aufweisend:

◦ nach dem Schritt des Bestimmens der Längsvariation $W_2=f_2(z)$ einen Schritt des Bestimmens (310) einer Kopplungseffektivität, die als das Verhältnis $P_{out}/P_{in}$ zwischen einem Parameter, der für eine optische Leistung $P_{out}$ einer Grundmode am Ausgang des Modenwandlers (3) repräsentativ ist, und einem Parameter, der für eine optische Leistung $P_{in}$ einer Grundmode am Eingang des Modenwandlers (3) repräsentativ ist, festgelegt ist,

◦ Wiederholen der Schritte vom Schritt des Festlegens bis zum Schritt des Bestimmens der Kopplungseffektivität für verschiedene Werte der Länge L;
◦ Bestimmen eines Minimalwerts der Länge L, für welchen die Variation der Kopplungseffektivität je nach der Länge L kleiner als oder gleich einer vorgegebenen Schwelle ist.

3. Herstellungsverfahren nach Anspruch 1 oder 2, aufweisend vor dem Schritt des Bestimmens von Ausbreitungskonstanten $\beta_e$ und $\beta_o$ die folgenden Schritte:

◦ Bestimmen (211) der Ausbreitungskonstante $\beta_1(W_1)$, die der Grundmode zugeordnet ist, die vom ersten Koppler (1c) getragen wird, der vom zweiten Koppler (2c) isoliert ist, je nach der Breite $W_1$, die von $W_{1,min}$ bis $W_{1,max}$ beträgt; und Bestimmen der Ausbreitungskonstante $\beta_2(W_2)$, die der Grundmode zugeordnet ist, die vom zweiten Koppler (2c) getragen wird, der vom ersten Koppler (1c) isoliert ist, je nach der Breite $W_2$, die von $W_{2,pmin}$ bis $W_{2,pmax}$ beträgt;
◦ Bestimmen (212) der Längsvariation $\hat{W}_2 = \hat{f}_2(z)$ zwischen den Positionen $z_0$ und $z_f$ einer provisorischen Breite $\hat{W}_2$ des zweiten Kopplers (2c), für welche die Abweichung zwischen den bestimmten Ausbreitungskonstanten $\beta_1(W_1)$ und $\beta_2(W_2)$ null ist;

und wobei der Schritt des Bestimmens von Ausbreitungskonstanten $\beta_e$ und $\beta_o$ das Bestimmen (221) der Längsvariation der Ausbreitungskonstanten $\beta_e$ und $\beta_o$ ausgehend von der zuvor festgelegten Längsvariation $W_1=f_1(z)$ und der zuvor festgelegten Längsvariation $\hat{W}_2 = \hat{f}_2(z)$ aufweist.

4. Herstellungsverfahren nach Anspruch 1 oder 2, wobei die Schritte des Bestimmens der Ausbreitungskonstanten $\beta_e$ und $\beta_o$ und des Bestimmens der Längsvariation $\kappa=h(z)$ die folgenden Schritte aufweisen:

◦ Bestimmen (222) der Ausbreitungskonstanten $\beta_e(W_1;W_2)$ und $\beta_o(W_1;W_2)$ je nach der Breite $W_1$, die von de $W_{1,min}$ bis $W_{1,max}$ beträgt, und der Breite $W_2$, die von $W_{2,pmin}$ bis $W_{2,pmax}$ beträgt;
◦ Bestimmen (232) der Längsvariation $\kappa=h(z)$ zwischen $z_0$ und $z_f$ je nach den zuvor bestimmten Ausbreitungskonstanten $\beta_e(W_1;W_2)$ und $\beta_o(W_1;W_2)$, für welche in jeder z-Position die Abweichung zwischen $\beta_e(W_1(z);W_2)$ und $\beta_o(W_1(z);W_2)$ minimal ist.

5. Herstellungsverfahren nach einem der Ansprüche 1 bis 4, wobei die festgelegte Längsvariation $W_1=f_1(z)$ der Breite $W_1$ eine monotone Funktion ist, und wobei die bestimmte Längsvariation $W_2=f_2(z)$ der Breite $W_2$ eine nicht monotone Funktion ist.

6. Verfahren zur Herstellung einer Hybrid-Laserquelle (4), die zwei Modenwandler (3) aufweist, die durch das Verfahren nach einem der vorhergehenden Ansprüche hergestellt sind, wobei die Hybrid-Laserquelle (4) Folgendes aufweist:

◦ ein Trägersubstrat (20), das einen integrierten Wellenleiter (2) mit einer Breite $W_2$ aufweist;
◦ ein Halbleiterpad (10), das auf dem Trägersubstrat (20) aufliegt, das Quantentöpfe (11) aufweist, die sich in einem aktiven Wellenleiter (1) mit einer Breite $W_1$ befinden, der durch die Modenwandler (3) adiabatisch an einen integrierten Wellenleiter (2) gekoppelt ist;
◦ wobei jeder Modenwandler (3) von einem aktiven Koppler (1c) des aktiven Wellenleiters (1) und einem integrierten Koppler (2c) des integrierten Wellenleiters (2) gebildet wird.

7. Herstellungsverfahren nach Anspruch 6, wobei das Halbleiterpad aus wenigstens einem III-V-Verbindungshalbleiter und das Trägersubstrat aus Silizium hergestellt ist.

8. Herstellungsverfahren nach Anspruch 6 oder 7, wobei die Länge L des Modenwandlers kleiner als 100 $\mu$m ist.

9. Herstellungsverfahren nach einem der Ansprüche 6 bis 8, wobei der Koppler (2c) des integrierten Wellenleiters (3) einer Dicke kleiner als oder gleich 300 nm aufweist.

**Claims**

1. Method for manufacturing a mode converter (3) ensuring adiabatic coupling between a first waveguide (1) and a second waveguide (2), the mode converter (3) being formed from a first coupler (1c) of the first waveguide (1) and from a second coupler (2c) of the second waveguide (2), the first and second couplers (1c, 2c) being superposed one on the other and having a width, $W_1$ and $W_2$ respectively, that varies over a length L along a longitudinal axis, the method comprising the following steps:

- o defining (100) on the one hand a longitudinal variation $W_1 = f_1(z)$, in the width $W_1$ of the first coupler (1c), between positions $z_0$ and $z_f$ along the longitudinal axis such that $z_f = z_0 + L$, from a maximum value $W_{1,max}$ at $z_0$ to a minimum value $W_{1,min}$ at $z_f$, and on the other hand minimum and maximum values $W_{2,pmin}$ and $W_{2,pmax}$, referred to as provisional values, of the width $W_2$ of the second coupler (2c);
- o determining (221; 222) propagation constants $\beta_e$ and $\beta_0$ associated with even and odd supermodes supported by the two couplers (1c, 2c), respectively, for each position z between $z_0$ and $z_f$ depending:

  - on the local value $W_1(z)$ in z of the width $W_1$ of the first coupler (1c), and
  - on a local value $\hat{W}_2(z)$ in z of the width $W_2$ of the second coupler (2c),

    - for which value the propagation constants $\beta_1(W_1(z))$ and $\beta_2(\hat{W}_2(z))$ respectively associated with the fundamental modes supported by the first coupler (1c) of local width $W_1(z)$ and by the second coupler (2c) of local width $\hat{W}_2(z)$ are equal, the two couplers (1c, 2c) then being isolated from each other;

- o determining (231; 232) a longitudinal variation $\kappa = h(z)$ between $z_0$ and $z_f$ in the coupling parameter $\kappa$ of the coupling between the two couplers (1c, 2c), on the basis of a difference between the determined propagation constants $\beta_e$ and $\beta_0$;
- o determining (300) a longitudinal variation $W_2 = f_2(z)$ between $z_0$ and $z_f$ in the width $W_2$ of the second coupler (2c) such that the adiabaticity criterion is met at each position *z*, this adiabaticity criterion relating the position *z* in question, the predefined length *L*, the predetermined coupling parameter $\kappa(z)$, said propagation constant $\beta_1(W_1(z))$, and a propagation constant $\beta_2(W_2(z))$ associated with a local value $W_2(z)$ to be determined;
- o manufacturing (400) the mode converter (3), in which mode converter the first coupler (1c) has the defined longitudinal variation $W_1 = f_1(z)$, and the second coupler (2c) has the determined longitudinal variation $W_2 = f_2(z)$.

2. Manufacturing method according to Claim 1, comprising:

- o following the step of determining the longitudinal variation $W_2 = f_2(z)$, a step (310) of determining a coupling efficiency defined as the ratio $P_{out}/P_{in}$ between a parameter representative of an optical power $P_{out}$ of a fundamental mode output from the mode converter (3) and a parameter representative of an optical power $P_{in}$ of a fundamental mode input into the mode converter (3),
- o reiterating the steps from the defining step to the step of determining the coupling efficiency, for various values of the length *L;*
- o determining a minimum value of the length *L* for which the variation in coupling efficiency as a function of the length *L* is smaller than or equal to a predefined threshold.

3. Manufacturing method according to Claim 1 or 2, comprising, before the step of determining propagation constants $\beta_e$ and $\beta_0$, the following steps:

- o determining (211) the propagation constant $\beta_1(W_1)$ associated with the fundamental mode supported by the first coupler (1c) isolated from the second coupler (2c), as a function of the width $W_1$, from $W_{1,min}$ to $W_{1,max}$; and determining the propagation constant $\beta_2(W_2)$ associated with the fundamental mode supported by the second coupler (2c) isolated from the first coupler (1c), as a function of the width $W_2$, from $W_{2,pmin}$ to $W_{2,pmax}$,
- o determining (212) the longitudinal variation $\hat{W}_2 = \hat{f}_2(z)$ between the positions $z_0$ and $z_f$ in a width $\hat{W}_2$, referred to as the provisional width, of the second coupler (2c), for which the difference between the determined propagation constants $\beta_1(W_1)$ and $\beta_2(W_2)$ is zero;

and wherein the step of determining propagation constants $\beta_e$ and $\beta_0$ comprises determining (221) the longitudinal variation in the propagation constants $\beta_e$ and $\beta_0$ on the basis of the longitudinal variation $W_1 = f_1(z)$ defined beforehand and of the longitudinal variation $\hat{W}_2 = \hat{f}_2(z)$ determined beforehand.

4. Manufacturing method according to Claim 1 or 2, wherein the steps of determining the propagation constants $\beta_e$ and $\beta_0$ and of determining the longitudinal variation $\kappa = h(z)$ comprise the following steps:

- o determining (222) propagation constants $\beta_e(W_1; W_2)$ and $\beta_0(W_1; W_2)$ as a function of the width $W_1$, from $W_{1,min}$ to $W_{1,max}$, and of the width $W_2$, from $W_{2,pmin}$ to $W_{2,pmax}$;

o determining (232) the longitudinal variation $\kappa = h(z)$ between $z_0$ and $z_f$ as a function of the propagation constants $\beta_e(W_1;W_2)$ and $\beta_0(W_1;W_2)$ determined beforehand, for which, at each position $z$, the difference between $\beta_e(W_1(z); W_2)$ and $\beta_0(W_1(z); W_2)$ is minimum.

5. Manufacturing method according to any one of Claims 1 to 4, wherein the defined longitudinal variation $W_1 = f_1(z)$ in the width $W_1$ is a monotonic function, and wherein the determined longitudinal variation $W_2 = f_2(z)$ in the width $W_2$ is a non-monotonic function.

6. Method for manufacturing a hybrid laser source (4) comprising two mode converters (3) fabricated using the method according to any one of the preceding claims, wherein the hybrid laser source (4) comprises:

o a carrier substrate (20), comprising a waveguide (2), referred to as the integrated waveguide, of width $W_2$;
o a semiconductor chip (10), resting on the carrier substrate (20), comprising quantum wells (11) located in a waveguide (1), referred to as the active waveguide, of width $W_1$, that is adiabatically coupled to an integrated waveguide (2) by the mode converters (3);
o each mode converter (3) being formed from a coupler (1c), referred to as the active coupler, of the active waveguide (1), and a coupler (2c), referred to as the integrated coupler, of the integrated waveguide (2).

7. Manufacturing method according to Claim 6, wherein the semiconductor chip is made of at least one III-V semiconductor compound, and the carrier substrate is made based on silicon.

8. Manufacturing method according to Claim 6 or 7, wherein the length $L$ of the mode converter is shorter than 100 $\mu$m.

9. Manufacturing method according to any one of Claims 6 to 8, wherein the coupler (2c) of the integrated waveguide (3) has a thickness smaller than or equal to 300 nm.

**Fig.1A**

**Fig.1B**

**Fig.2**

**Fig.3**

$$100 \quad W_1 = f_1(z) \ / \ W_1(z_0) = W_{1,min} \ ; \ W_1(z_f = z_0 + L) = W_{1,max}$$
$$W_{2,pmin} \ ; \ W_{2,pmax}$$

$$211 \quad \beta_1(W_1) \quad ; \ W_1 \in [W_{1,min}; W_{1,max}]$$
$$\beta_2(W_2) \quad ; \ W_2 \in [W_{2,pmin}; W_{2,pmax}]$$

$$212 \quad \widehat{W}_2 = \hat{f}_2(z) \ / \ \forall z \in [z_0; z_f], \ \beta_1[W_1(z)] - \beta_2[\widehat{W}_2(z)] = 0$$

$$221 \quad \forall z \in [z_0; z_f], \quad \beta_e = g_e(z) = g_e[W_1(z); \widehat{W}_2(z)]$$
$$\forall z \in [z_0; z_f], \quad \beta_o = g_o(z) = g_o[W_1(z); \widehat{W}_2(z)]$$

$$231 \quad \forall z \in [z_0; z_f], \ \kappa = h(z) = [ \ \beta_e(z) - \beta_o(z) \ ]/2$$

200

$$300 \quad W_2 = f_2(z) \ / \ \forall z \in [z_0; z_f],$$
$$\tan\left( \operatorname{asin} \frac{2(z - z_0)}{L} \right) = \frac{\delta(z)}{\kappa(z)} = \frac{\beta_2(W_2(z)) - \beta_1(W_1(z))}{2 \times \kappa(z)}$$

$$400 \quad W_1 = f_1(z)$$
$$W_2 = f_2(z)$$

**Fig.4**

**100**

$W_1 = f_1(z) \ / \ W_1(z_0) = W_{1,min} \ ; \ W_1(z_f = z_0 + L) = W_{1,max}$
$W_{2,pmin} \ ; \ W_{2,pmax}$

**222**

$\beta_e(W_1;W_2) \ ; \ W_1 \in [W_{1,min};W_{1,max}] \ ; \ W_2 \in [W_{2,pmin};W_{2,pmax}]$
$\beta_o(W_1;W_2) \ ; \ W_1 \in [W_{1,min};W_{1,max}] \ ; \ W_2 \in [W_{2,pmin};W_{2,pmax}]$

**200**

**232**

$\forall z \in [z_0;z_f], \ \kappa = h(z) = [ \ \beta_e[W_1(z);\widehat{W}_2(z)] - \beta_o[W_1(z);\widehat{W}_2(z)] \ ]/2$

**300**

$$W_2 = f_2(z) \ / \ \forall z \in [z_0;z_f],$$

$$\tan\left(\operatorname{asin} \frac{2(z-z_0)}{L}\right) = \frac{\delta(z)}{\kappa(z)} = \frac{\beta_2(W_2(z)) - \beta_1(W_1(z))}{2 \times \kappa(z)}$$

**400**

$W_1 = f_1(z)$
$W_2 = f_2(z)$

**Fig.5**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2016266321 A

**Littérature non-brevet citée dans la description**

- **DUAN et al.** Hybrid III-V on Silicon Lasers for Photonic Integrated Circuits on Silicon. *IEEE J. Sel. Topics Quantum Electron.,* 2014, vol. 20 (4
- **DUPREZ et al.** 1310nm hybrid InP/InGaAsP on silicon distributed feedback laser with high side-mode suppression ratio. *Optics Express,* 2015, vol. 23 (7
- **SUN et al.** Adiabaticity criterion and the shortest adiabatic mode transformer in a coupled-waveguide system. *Opt. Lett.,* 2009, vol. 34, 280
- **SUN ; YARIV.** Engineering supermode silicon/III-V hybrid waveguides for laser oscillation. *J. Opt. Soc. Am. B,* 2008, vol. 25 (6), 923